# EUROPEAN PATENT APPLICATION

(11) **EP 2 039 940 A2**
(43) Date of publication of application: **25.03.2009**
(21) Application number: 08158448.4
(22) Date of filing: 18.06.2008
(51) Int. Cl.: F04D 17/12, F04D 17/16

(54) **Radially staged microscale turbomolecular pump**

(30) Priority: 21.09.2007 US 859682
(71) Applicant: Honeywell International Inc., Morristown NJ 07960 (US)
(72) Inventor: Yang, Wei, Minnetonka, MN 55345 (US)
(74) Representative: Buckley, Guy Julian

(57) **Abstract**

A radial turbomolecular vacuum pump that includes a rotor made from a silicon rotor surface comprising monolithically fabricated micro blades, and a stator made from a silicon stator surface comprising corresponding monolithically fabricated grooves. The micro blades and grooves are arranged in multiple rings, and the rotor and stator disks are placed in proximity, creating interdigitated stator and rotor blade rings. The interdigitated stator and rotor blade rings form a multi-stage compression in the radial direction.

## Description

### FIELD

The present invention relates generally to the field of vacuum pumps. More particularly, the present invention relates to the design and manufacture of miniature turbomolecular vacuum pumps.

### BACKGROUND

Turbomolecular pumps are a type of vacuum pump used to obtain and maintain high vacuum. A conventional turbomolecular pump is capable of high vacuum level and pump speed. However, the conventional turbomolecular pump is too bulky for most portable applications, such as use with micro-instrumentation. For example, the rotor diameter is typically sized to greater than 75 mm, which results in the turbomolecular pump size being inconveniently large for portable applications.

In addition, a conventional turbomolecular pump is only able to operate against a fairly low exhaust pressure, typically less than 10 millitorr, and a first-stage or foreline pump must be used between the turbomolecular pump exhaust and the atmosphere. It is difficult to find a miniature pump capable of reaching values of less than 10 millitorr pressure to be used as the first stage pump. For example, most commercially available miniature pumps at present typically are only able to achieve pressures on the order of 100 torr. Therefore, it is desirable for a miniature turbomolecular pump to be able to work against exhaust pressures larger than 10 torr.

Attempts to produce portable vacuum pumps have had limited success due to difficulty in achieving required pumping capacity with a compact pump design.

### SUMMARY

The present invention relates to a turbomolecular pump that can produce a high vacuum against a high exhaust pressure, such as pressures larger than 10 torr, yet may be used in instrumentation where the application may be portable, hand held or space limited. Examples of these types of instruments are mass spectrometers, electron microscopes, small gas detectors, and gas analyzers.

In one embodiment, the present invention features a radial turbomolecular vacuum pump that includes a gas inlet, a gas outlet, a motor, a rotor, a stator, and a casing. The rotor includes a silicon rotor surface comprising monolithically fabricated micro blades. The stator includes a silicon stator surface comprising monolithically fabricated blades and grooves. The micro blades on the rotor and stator, respectively, are arranged in multiple rings, and the rotor and stator disks are placed in proximity, forming interdigitated stator and rotor blade rings. The interdigitated stator and rotor blade rings form a multi-stage compression in the radial direction.

The microfabrication allows for the creation of blades on the rotor and stator in dimensions smaller than the mean free path of gas molecules, even at the high limit of the exhaust pressure of 10 torr. With the silicon etching method used for monolithic fabrication, multiple blade rings can be made easily and the number of stages of compression in the radial direction (e.g., 100 stages) can be achieved. One advantage of increasing the number of stages within each rotor and stator pairing is that the same compression ratio can be achieved at a lower rotor speed, leading to lower power consumption and less stringent bearing requirements.

### BRIEF DESCRIPTION OF THE DRAWINGS

Figure 1 illustrates an exemplary view of a radial flow turbomolecular pump;
Figure 2A illustrates an exemplary cutaway view of a stator and rotor;
Figure 2B is an enlarged partial view of the stator;
Figure 2C is an enlarged partial view of the rotor;
Figure 3 is an exemplary cutaway view of the rotor and stator in a position in which the rotor and stator operate;
Figure 4 illustrates an exemplary fabrication process for a turbomolecular pump with an external motor; and
Figure 5 illustrates an exemplary fabrication process for a turbomolecular pump with an on-chip electromagnetic motor and bearing.

### DETAILED DESCRIPTION

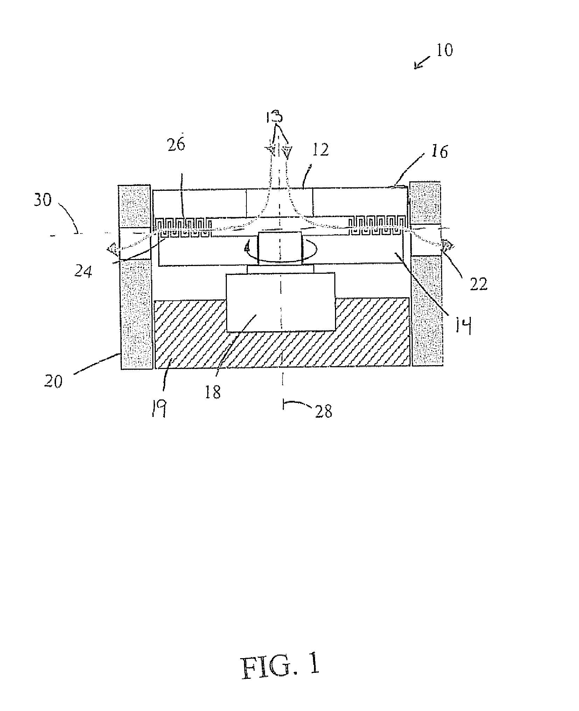

FIG. 1 illustrates an exemplary view of a radial flow turbomolecular pump 10. The pump 10 includes an inlet 12, a rotor 14, a stator 16, a motor 18, a casing 20, and a plurality of outlets 22. The rotor 14 includes a plurality of rotor blades 24. The stator 16 includes a plurality of stator grooves 26.

Casing 20 encloses rotor 14 stator 16. Motor mount 19 holds motor 18 in place and aligns motor 18 with rotor 14 and stator 16. Inlet 12 serves to allow an amount of gas 13 to enter casing 20 and flow into rotor 14.

Each groove of the plurality of stator grooves 26 is positioned to receive each blade of the plurality of rotor blades 24. In the assembled state, stator 16 is fixed and rotor 14 is free to spin.

A rotor circumferential speed can range from 10 to 300 m/s, depending on a needed compression ratio and gas flow. The rotation of rotor 14 relative to stator 16 causes gas to be pumped radially outward, away from an axial centerline 28 or radially inward toward axial centerline 28.

In operation, motor 18 moves rotor 14 so that the rotor rotates relative to stator 16. When the rotor rotates, the plurality of rotor blades 24 passes through a respective one of the plurality of stator grooves 26. As gas molecules enter via inlet 12, the plurality of rotor blades 24 and stator grooves 26 impact the molecules, causing the molecules to gain momentum in the radial direction. This process is continued until the gas molecules are lead through an outlet of the plurality of outlets 22 and outside casing 20. The dimension of the gas flow path parallel to a radial centerline 30 is greater than the dimension of the gas flow path parallel to axial centerline 28, resulting in a radial flow of the gas molecules.

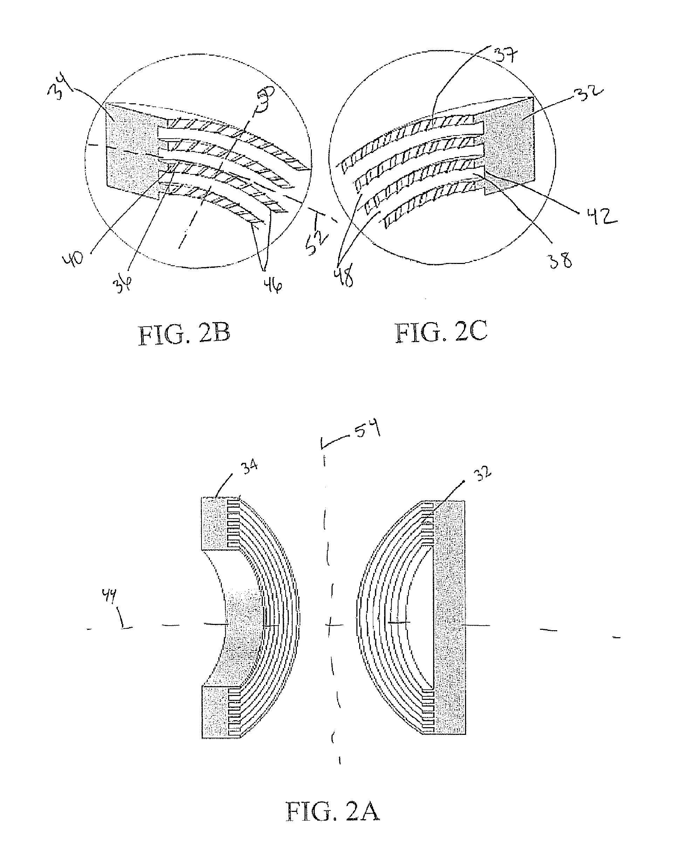

FIG. 2A illustrates a cutaway view of an exemplary stator 32 and rotor 34. FIG. 2B illustrates a partial augmented view of rotor 34. Rotor 34 and stator 32 are each formed from a silicon substrate. Each blade of the plurality of rotor blades 36 extends axially from a first rotor surface 40, that is, in a substantially parallel direction to an axial centerline 44. The plurality of rotor blades 36 are arranged in rotor concentric rings 46 on rotor surface 40. A plurality of stator blades 37 and a plurality of stator grooves 38 are arranged on a stator surface 42 in stator concentric rings 48. The plurality of stator grooves 38 are arranged to fit between concentric rings 46 of plurality of rotor blades 36.

The plurality of rotor blades 36 may be monolithically fabricated on first rotor surface 40 of rotor 34 using an etching process. The plurality of stator blades 37 may be monolithically fabricated on first stator surface 42 of stator 32 using an etching process.

An exemplary etching process may be deep reactive ion etching. In this process, silicon substrates are places inside a vacuum chamber and are usually grounded and electrically isolated from the rest of the chamber. An etch mask is placed on the silicon substrate to selectively protect areas of the substrate. Gas then enters the chamber and etches the unprotected portions of the silicon substrate; thus the substrate takes on a form that is dictated by the mask. An example of a gas that may be used for this process is sulfur hexafluoride. However, the fabrication process is not limited to using sulfur hexafluoride, and a number of other gases may be used. As an alternative to gas, plasma may be used to etch the silicon substrate. Another etching process may be photo assisted wet chemical etching. Both sides of rotor 34 or stator 32 may be processed using an etching process. The etching process allows for the blades to be monolithically fabricated on the rotor. With monolithic fabrication, multiple rings of blades and grooves can be easily made, forming a large number of stages, for example, 100 stages. When the number of stages is increased, the same compression ratio can be achieved at a lower rotor speed. When turbomolecular pump 10 operates at a lower rotor speed, less power is consumed. Additionally, the ability to operate at a lower rotor speed will result in less stringent bearing requirements and less wear on the bearings of the turbomolecular pump. A plating/LIGA process may be used as well. In this process, a layer of photosensitive polymer is coated on the silicon substrate, followed by x-ray radiation using an x-ray mask.

Each blade of the plurality of rotor blades 36 is thick enough to be stable under high speed rotation, yet thin for efficient compression. In one embodiment, the size of each blade of the plurality of rotor blades 36 is approximately 10 micron, which allows the pump to work against 10 torr exhaust pressure. However, the blades are not limited to this size, and a number of other sizes may be used for other operating conditions.

The plurality of rotor blades 36 are shaped and positioned to achieve a certain pumping speed, compression, and efficiency. The pitch of each blade of the plurality of rotor blades 36 generally determines the pumping speed and compression. As an example, tilting the plurality of rotor blades 36 towards a radial direction 50 will generally result in a higher pumping speed. Tilting the plurality of rotor blades 36 towards a circumferential direction 52 will result in higher compression, yet lower pumping speed. The blades of the plurality of rotor blades 36 near the center of rotor 34 may be larger than the blades at the edge of rotor 34, because the pressure near the center of rotor 34 is lower.

The silicon monolithic fabrication allows for stator 32 and rotor 34 to be manufactured very small in size. In an exemplary embodiment, stator 32 and rotor 34 are each 10 mm in diameter. However, stator 32 and rotor 34 are not limited to this size.

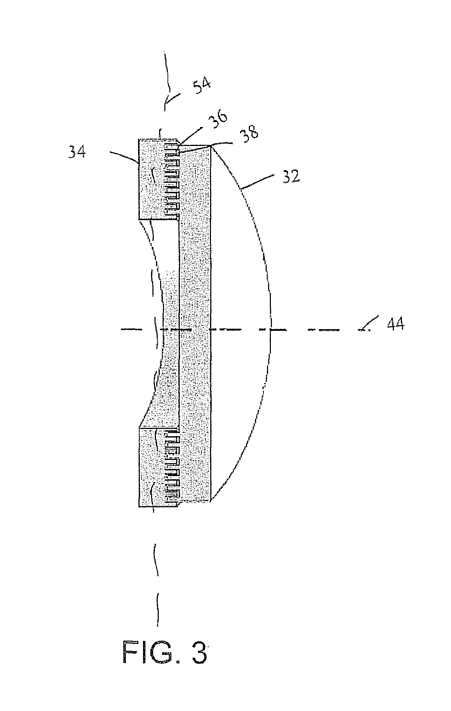

FIG. 3 illustrates a cutaway view of the rotor and stator pair from FIG. 2 in the operating position. As is shown in FIG. 3, first rotor surface 40 is positioned in a substantially parallel direction to radial centerline 50. First stator surface 42 is positioned proximate to first rotor surface 40, and is also substantially parallel to a radial centerline 54. First stator surface 42 is positioned so that it does not touch first rotor surface 40. The plurality of stator grooves 38 effectively form grooves for receiving the corresponding plurality of rotor blades 36.

The silicon monolithic fabrication allows for the plurality of rotor blades 36 to be made with high precision, so that each blade of the plurality of rotor blades 36 fits within the corresponding stator groove 38 within a specified tolerance. In an exemplary embodiment, a lateral clearance between at least one blade of the plurality of rotor blades 36 and the first and second plurality of stator grooves 38 is approximately 5 micron. However, the distance is not limited to 5 micron, and may comprise other values as well. The rotor blades may be as close to the grooves as possible.

Assembling the rotor 34 and stator 32 generally requires a tolerance of about 5 to 10 micrometers. This can be accomplished by assembling rotor 34 and stator 32 in a precision bore tubing after aligning and bonding rotor 34 and stator 32 to carrier disks, which have precision matching outer diameters.

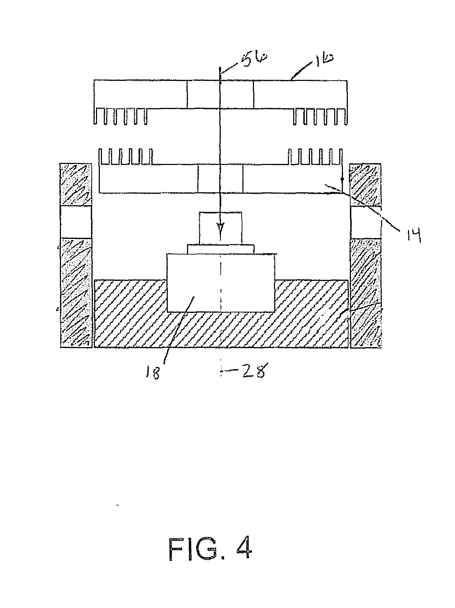

FIG. 4 illustrates an assembly for the turbopump with an external motor. In this configuration, rotor 14 and stator 16 are concentrically mounted in the direction of arrow 56 on motor 18 so that rotor 14 is placed on motor 18, as shown in the assembled state in FIG. 1. Motor 18 may be concentrically mounted via a precision mount base.

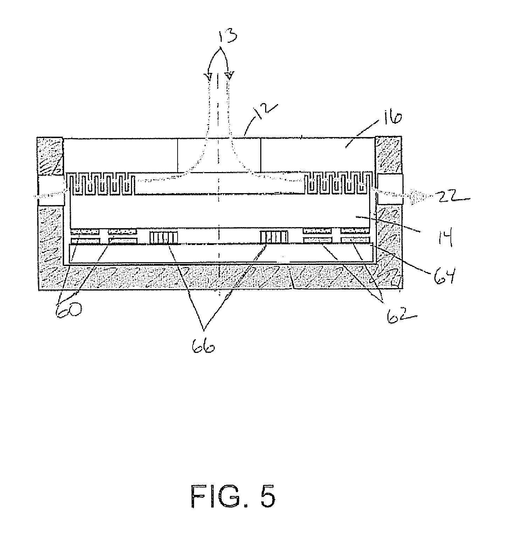

FIG. 5 illustrates an alternative configuration for the turbopump with on-chip magnetic bearing. In this embodiment, rotor 14 is operated using permanent magnets 60. Permanent magnets 60 may be embedded in rotor 14 and driven by planar coils 62 positioned in a facing surface 64. A levitation external circuit may drive planar coils 62. Position sensors 66 determine the position of rotor 14.

## Claims

1. A radial turbomolecular vacuum pump, comprising:
a gas inlet;
a rotor comprising:
a first rotor surface; and
a plurality of rotor blades, wherein the plurality of rotor blades are monolithically fabricated from the first rotor surface and extend axially from the first rotor surface, wherein the material of the first rotor surface and the plurality of rotor blades is silicon;
a stator comprising:
a first stator surface that is positioned proximate to the first rotor surface
in the substantially radial direction;
a plurality of stator blades, wherein the plurality of stator blades are monolithically fabricated from the first stator surface and extend axially from the first stator surface; and
a plurality of stator grooves formed between from the plurality of stator blades, wherein the stator surface and the plurality of stator blades and the plurality of stator grooves are manufactured from silicon; and
a gas outlet.

2. The turbomolecular vacuum pump of claim 1, wherein the plurality of rotor blades are arranged in concentric rings of blades.

3. The turbomolecular vacuum pump of claim 2, wherein the plurality of stator grooves are arranged in concentric rings and are disposed between the concentric rings of the plurality of rotor blades.

4. The turbomolecular vacuum pump of claim 1, wherein the rotor and the stator are manufactured using a deep reactive ion etching process.

5. The turbomolecular vacuum pump of claim 1, wherein the rotor and stator are manufactured using a photo assisted wet chemical etching process.

6. The turbomolecular vacuum pump of claim 1, wherein the plurality of stator blades are within a range of 10 to 50 micron.

7. The turbomolecular vacuum pump of claim 1, wherein the plurality of rotor blades are within a range of 10 to 50 micron.
